# EUROPEAN PATENT SPECIFICATION

(11) **EP 4 377 704 B1**
(45) Date of publication and mention of the grant of the patent: **17.12.2025**
(21) Application number: 22747398.0
(22) Date of filing: 20.07.2022
(51) Int. Cl.: G01R 31/11

(54) **MONITORING ELECTRICAL SYSTEMS WITH MULTIPLE GROUND CONNECTION POINTS**
ÜBERWACHUNG ELEKTRISCHER SYSTEME MIT MEHREREN ERDUNGSPUNKTEN
SURVEILLANCE DE SYSTÈMES ÉLECTRIQUES AVEC PLUSIEURS POINTS DE MISE À LA TERRE

(30) Priority: 28.07.2021 GB 202110851
(43) Date of publication of application: 05.06.2024
(73) Proprietor: Viper Innovations Ltd, Portishead Bristol BS20 7AW (GB)
(72) Inventor: DENNING, Dan, Bristol BS20 7AW (GB); XU, Guangqiao, Bristol BS20 7AW (GB); PETIT, Aurelien, Bristol BS20 7AW (GB)
(74) Representative: Marks & Clerk LLP
(86) International application number: PCT/GB2022/051879
(87) International publication number: WO 2023/007125

(56) References cited:
- CN-A- 108 535 605
- US-A1- 2015 236 643
- US-A1- 2017 010 314
- EDUN AYOBAMI S ET AL: "Spread Spectrum Time Domain Reflectometry With Lumped Elements on Asymmetric Transmission Lines", IEEE SENSORS JOURNAL, IEEE, USA, vol. 21, no. 2, 20 January 2020 (2020-01-20), pages 921 - 929, XP011826502, ISSN: 1530-437X, [retrieved on 20201217], DOI: 10.1109/JSEN.2020.2967894

## Description

### Background

Reflectometry can be used to detect faults in electrical networks. Some reflectometry methods involve injecting a signal into the electrical network, detecting a reflected signal, and identifying an impedance variation in the electrical network by correlating the injected signal with the reflected signal.

It is desirable to monitor electrical systems such as, but not limited to, overhead line equipment of railways, trolleybuses, trams and the like. Overhead line equipment refers to overhead wires and supporting equipment that vehicles such as trains electrically contact in order to receive electric power. Normally, such vehicles utilise an extending pantograph to contact an overhead wire of overhead line equipment. Components of overhead line equipment is prone to damage, vandalism and/or theft. It is therefore desirable to determine if components of the overhead line equipment are damaged, vandalised or stolen. It is also desirable to monitor other types of electrical systems such as electrical transmission cables, or any other type of electrical system for transmitting electricity over a long distance. CN108535605A relates to a pulse waveform comparison method for fault monitoring of direct-current grounding electrode lines. US2017/010314A1 relates to systems and methods for health monitoring of electrical systems. US2015/236643A1 relates to systems and methods for fault detection.

### Summary

According to a first aspect, there is a provided a method for monitoring an electrical system having multiple electrical ground connection points according to claim 1. The method comprises receiving reflectometry data that has been generated by performing time domain reflectometry on the electrical system, the time domain reflectometry being performed during a measurement time period; determining a measured waveform from the reflectometry data, the measured waveform indicative of a measured state of the system during the measurement time period; obtaining a predetermined baseline waveform indicative of a baseline state of the system during a calibration time period; generating a difference waveform based on the measured waveform and the baseline waveform; and analysing the difference waveform to determine if there is a change of state in the electrical system between the calibration time period and measurement time period.

The method provides for a precise determination of a change of state of the multiple grounded electrical system. For example, it may be recognised that certain difference waveforms are indicative of particular types of change of state, and optionally, a location of the change of state. As used herein, the term "change of state" may refer to an unauthorised modification/removal of any conductive element of the electrical system, or, an electrical fault, such as a short-circuit. The method enables an operator to determine the nature of the change of state and take appropriate remedial action in a timely fashion. For example, based on the difference waveform, the operator may determine that a particular component needs replacing. The particular component can be arranged for delivery to the fault site even before the fault has been inspected in-situ. The operator may also be able to quickly determine that a conductive element of the electrical system has been stolen, or even that it is in the process of being disconnected in an unauthorised manner, thereby enabling timely remedial action. The method reduces the risk of catastrophic failure of the electrical system, improves fault detection and timely repair, and ensures safe operation.

The term "electrical system" as used herein may refer to an electrical circuit comprising at least one electrical conductor that has multiple ground connection points. The electrical system need not have an electricity supply. Such an electrical system may be monitored in accordance with the techniques disclosed herein to monitor the quality of the earthing of the at least one electrical conductor. For example, the electrical system may comprise a permanently earthed section of a railway line.

Optionally, the time domain reflectometry is performed by transmitting and receiving signals along a grounded conductor having multiple electrical ground connection points.

Optionally, the change of state comprises a change of state of a ground connection of the electrical system.

Optionally, the change of state comprises a change to a conductive structure supporting a conductor of the electrical system.

Where the electrical system is an overhead line comprising a conductive wire, the conductive structure may be a mast supporting the conductive wire. The mast may be connected to ground.

It is desirable to monitor the state of components providing the ground connections. Such components are normally located close to the ground (where earth is acting as ground), so are susceptible to theft. This is particularly the case for permanently earthed sections, since electrical current does not normally flow through the section. Theft of these components renders the electrical system more dangerous due to the reduction of ground connection paths that are available during an electrical system fault such as a short-circuit. Theft of such components have previously been difficult to detect, since their absence may only be noticed in the event of a system fault. Any disruption to any ground connection can be detected based on an analysis of the difference waveform and an alarm can be initiated to immediately notify operators. Furthermore, there is provided the ability to detect permanent and intermittent faults (e.g. arc faults) on ground connections.

Optionally, the reflectometry is one of time domain reflectometry (TDR), Sequence Time Domain Reflectometry (STDR), and Spread Spectrum Time Domain Reflectometry (SSTDR).

Whilst the scope of this disclosure encompasses various types of reflectometry, SSTDR reflectometry is particularly favourable since SSTDR signals can be isolated from activity and noise generated by the monitored electrical system during operation. Therefore, an electrical system can be monitored even during routine operation.

Optionally, analysing the difference waveform comprises determining if there is a change of state based on an amplitude of the difference waveform.

Optionally, analysing the difference waveform comprises determining if there is a change of state based on a location of a peak of the difference waveform.

Optionally, analysing the difference waveform comprises inputting the difference waveform into a trained classifier for determining if there is a change of state in the electrical system.

Use of a trained classifier provides for an improved and efficient determination of the type and/or location of a change of state of the electrical system based on the difference waveform. The trained classifier can be continuously trained to recognise difference waveforms as relating to different types of change of state. The trained classifier can also be trained to recognise certain difference waveforms as not relating to a problematic change of state, for example, where the electrical system is temporarily affected by adverse weather or the movement of any vehicles that are connected to the electrical system. The trained classifier may be an artificial neural network.

Analysing the difference waveform comprises comparing the difference waveform with two or more stored difference waveforms, wherein each of the two or more stored difference waveforms corresponds to a known change of state.

The comparison may comprise undertaking a computational similarity analysis between the difference waveform and the stored difference waveforms. The stored waveforms difference waveforms may have been generated and stored during an earlier period of time (e.g. the calibration time period), such as during controlled simulations of different changes of state. The analysis may involve a comparison of portions of the difference and stored waveforms. Such analysis may involve use of a Fourier transform function to obtain a representation of the waves in the frequency domain. It is possible to store a large number of waveforms corresponding to a variety of known changes of state. The comparison provides for a determination of a change of state of the system without requiring visual inspection of the electrical system itself.

Optionally, the reflectometry data is received by a local monitoring system, and is transmitted to a server which is remote to the local monitoring system, and wherein the difference waveform is analysed by the server.

The step of analysing may require a significant amount of processing power. Furthermore, it may be desirable to utilise a single processing unit (e.g. of the server) for undertaking the analysis of difference waveforms for multiple different electrical systems. This may be efficient where, for example, the analysis utilises a database of stored waveforms, or where the analysis utilises an artificial neural network.

Optionally, analysing the difference waveform comprises determining one or both of a location within the electrical system, and a type of any change of state based on the difference waveform.

It is advantageous that not only the presence of a fault/change of state is detected, but rather that a type and/or location of the fault can be ascertained. An operator can therefore take appropriate responsive action in a quick manner.

Optionally, the method further comprises generating an alarm when a change of state is determined, and generating an indication of the one or both of the location and type of change of state.

Optionally, the method further comprises obtaining a plurality of sets of reflectometry data of the electrical system, wherein each set of reflectometry data is obtained under a different simulated change of state of the system, and wherein each of the plurality of sets of reflectometry data comprise a simulated difference waveform corresponding to the respective simulated change of state of the system, and wherein each simulated difference waveform is stored as training data.

Obtaining and storing reflectometry data under simulated states of change enables the monitoring method to be tailored for particular electrical systems that are to be monitored, thereby improving the accuracy of the determination of changes of state. Obtaining and storing reflectometry data may be undertaken during the calibration time period.

Optionally, the method further comprises training a classifier by inputting the plurality of sets of reflectometry data and corresponding simulated change of state of the system into the classifier.

According to a further aspect there is provided an apparatus for monitoring an electrical system, the apparatus comprising a processing unit configured to undertake the method described herein.

Optionally, the apparatus further comprises a reflectometry generator configured to be connected to a conductor of the electrical system, the reflectometry generator configured to obtain test reflectometry data of the electrical system.

The reflectometry generator is one of a TDR, STDR, and SSTDR reflectometry generator. Where the electrical system is an overhead line comprising a conductive wire supported by a plurality of conductive masts, the conductive masts providing a ground connection point, then the reflectometry generator may be connected between one of the conductive masts and the conductive wire.

Optionally, the processing unit is located on a server remote to the electrical system.

According to a further aspect there is provided a computer-readable storage medium comprising instructions for execution by a processor, wherein the instructions are configured to cause the processor to perform the method described herein.

The skilled person will appreciate that except where mutually exclusive, a feature described in relation to any one of the aspects, examples or embodiments described herein may be applied to any other aspect, example, embodiment or feature. Further, the description of any aspect, example or feature may form part of or the entirety of an embodiment of the invention as defined by the claims. Any of the examples described herein may be an example which embodies the invention defined by the claims and thus an embodiment of the invention.

### Brief Overview of Figures

The invention will now be described, by way of example only, with reference to the accompanying drawings, in which:
Figure 1 shows an electrical system with an attached monitoring apparatus.
Figure 2 is a diagram showing components of the monitoring apparatus of Fig. 1.
Figure 3 is a flow diagram of an example method performed by the monitoring apparatus of Fig. 2.
Figure 4 is a plot of correlated baseline and measured waveforms obtained from the monitoring apparatus of Fig. 2.
Figure 5 is a plot of the difference between the baseline waveform and measured waveform of Fig. 4.
Figure 6 shows a test rig installation for testing functionality of systems and methods of this disclosure, and being representative of a real-world implementation of systems and methods of this disclosure.
Figures 7 to 15 show plots of waveforms resulting from tests undertaken using the test rig of Fig. 6.

### Detailed description

Disclosed herein are systems and methods suitable for monitoring electrical systems. The disclosed systems and methods are particularly suitable for detecting and locating changes to a permanently earthed sections (PES), which are often part of the Overhead Line Equipment (OLE) utilised by railways, tramlines, trolleybuses, and the like. Permanently earthed sections are sections of an OLE which are not live and may be utilised for sections of the line where there is human contact due to maintenance. Alternatively, permanently earthed sections may be utilised where it is not possible to place equipment that is required for live sections due to environmental factors or space considerations, such as under low bridges. PES sections enable a pantograph of a train to maintain contact with a section of overhead wire which is not electrically powered. PES sections typically cross several spans of OLE, each span being separated by a supporting mast. It is desirable to monitor changes to PES as a result of cable cuts, or components such as jumpers and droppers being removed due to theft. The disclosed systems and methods provide for an operator to be notified when there is such a change to the electrical system, thereby helping to guard against the theft of a component and/or providing an immediate alarm when safety-critical damage has occurred. The methods and systems of the present disclosure are particularly advantageous in that an operator is sometimes able to determine precisely what type of change has occurred, and the location of the change, thereby enabling prompt remedial action. Furthermore, if the electrical system is a permanently earthed system, then the operator is able to detect any faults or changes of state of any ground connections.

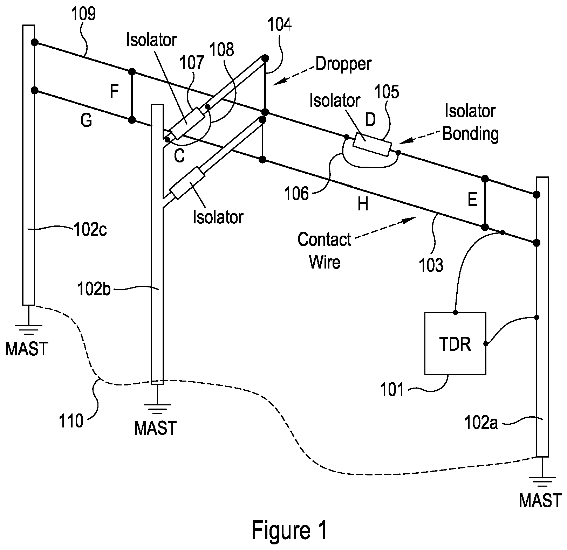

With reference to Fig. 1, there is shown an example arrangement for monitoring an electrical system. In the shown example, the electrical system is a PES such as the type utilised to provide a non-live section of an overhead line for a train. This electrical system is discussed purely by way of example, and the same monitoring principles can be applied to other types of electrical systems not necessarily in the field of train line electrification. A monitoring apparatus 101 is connected between a mast 102a and a conductor 103 of the PES. The PES may include multiple masts 102a, 102b, 102c. Each of the masts are conductive, and are electrically connected to ground (which in this case is earth), and provide a conducting path from the conductor 103 to ground. As used herein, the term "ground connection" may refer to a physical electrical connection to the earth. The PES may include components such as isolators 105, 107 and corresponding jumpers 106, 108 for allowing current to bypass the isolators 105, 107. The PES may further comprise a dropper 104 for maintaining the conductor 103 at a particular distance below a messenger cable 109. In operation, the monitoring apparatus 101 is typically configured to generate and receive test reflectometry data of the PES by injecting an electrical signal into the conductor 103 by applying a voltage thereto. The signal may be a pulse, a series of pulses, or some other signal with high frequency (e.g. 10Mhz to 1000Mhz) components. The injected signal propagates along the conductor 103 towards ground, via the masts 102b, 102c. If there is any change in impedance on the conductor 103 or other conducting components such as jumpers 106, 108, a portion of the injected signal is reflected back along the conductor. In other words, some of the electrical power in the injected signal goes to ground, but a portion of the electrical power is reflected at a point on the conductor at which the impedance changes. The reflected portion is received at the monitoring apparatus 101, where it can be measured, sampled or otherwise analysed. The state of the PES can be monitored by analysing the reflected signal. As will be described in more detail below, changes to the system such as breakage of the dropper 104, removal of any portion of the conductor (contact wire) 103, or removal of the jumpers 106, 108 will cause a detectable change in the reflected signal.

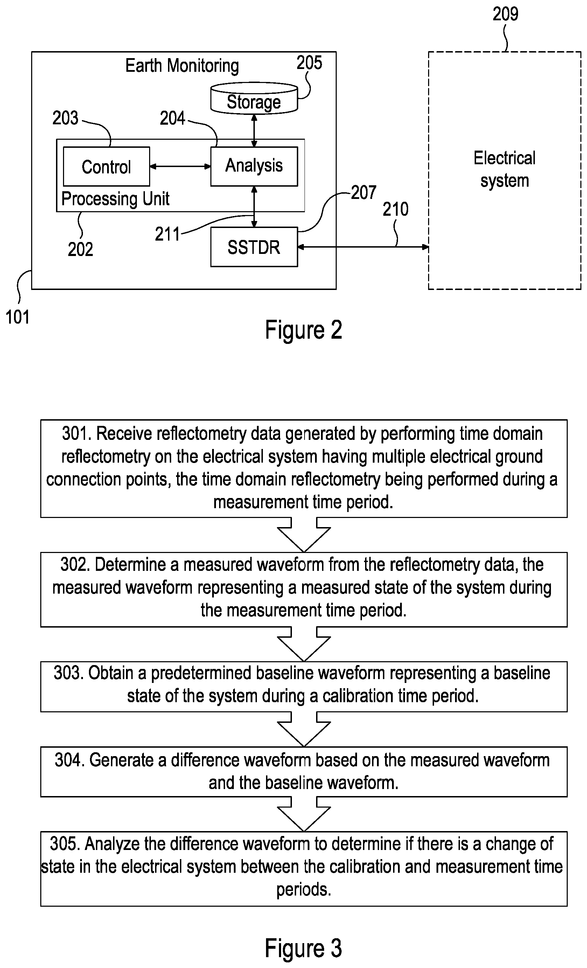

With reference to Fig. 2, the monitoring apparatus 101 comprises a reflectometry generator 207. In the Example of Fig. 2, the reflectometry generator 207 is a Spread Spectrum Time Domain Reflectometry (SSTDR) generator. However, the reflectometry generator could alternatively be any of one of a Time Domain Reflectometry (TDR) or a Sequence Time Domain Reflectometry (STDR) generator. Such reflectometry generators may be considered to be reflectometry transceivers, which are configured to transmit electrical signals through an electrical system, and receive a reflected electrical signal. The monitoring apparatus 201 also comprises a processing unit 202 and a storage device 205. The processing unit 202 may comprise a control unit 203 and an analysis module 204. The processing unit 202 and storage device 205 may be embodied in one or more computing devices comprising a processor, electronic data storage, and a user input/output device. Such one more computing devices may comprise a personal computing device, a portable computing device, an embedded computing device, and/or the like. The reflectometry generator 207 is connected to an electrical system 209 via a connecting line 210. In operation, the reflectometry generator 207 obtains reflectometry data by transmitting and receiving electric signals via the connecting line 210 to and from the PES 209. The reflectometry data may be electronic data (e.g. digitised waveforms) defining both of the transmitted and received electrical signals. The transmitted and received signals are typically correlated to produce a measured waveform. The measured waveform may be data indicative of a plot of amplitude of the signal over time/distance, or a plot of the signal in the frequency domain. As used herein, the term "waveform" can refer to data indicative of a sample of a wave generated by an electric signal over a predetermined distance or time. Such samples may be known as waveform signatures. In examples, a difference waveform is acquired by comparing (typically subtracting) the measured waveform with a stored baseline waveform. The stored baseline waveform is obtained via the same reflectometry methodology as the measured waveform, except that it is obtained at a different time when it is known that there is no change of state in the monitored electrical system. The baseline waveform is typically obtained during calibration or initial setup of the monitoring apparatus 101. The baseline waveform effectively provides a unique signature of the monitored electrical system and can be stored on the storage device 205. Typically, the storage device 205 is electronic memory that is accessible by a computer and the baseline waveform is digitally stored on the storage device 205. Where the electrical system 209 is a permanently earthed system, the baseline waveform is indicative of the grounding arrangement of the electrical system. The existence of faults and/or changes in the state of the PES 209, and optionally the location of such faults/changes of state, are determined based on analysis of the acquired difference waveform. In some examples, the acquired difference waveform is compared to one or more predetermined stored difference waveforms, which have been obtained by previous measurements, and which are stored on storage device 205. The comparison of the acquired difference waveform and stored difference waveforms may be undertaken computationally. The comparison may comprise comparing the spectral shapes of the waveforms. The comparison be undertaken in the time or frequency domains. In this case, the stored difference waveforms each correspond to a known change of state of the PES 209, and therefore the type and/or location of the change of state can be determined based on the comparison of acquired and stored difference waveforms.

Where the reflectometry generator 207 is a Spread Spectrum Time Domain Reflectometry (SSTDR) generator, the transmitted and received signals may be correlated in the following manner. First, a digital message of the transmitted signal may be encoded with a bit sequence (e.g. a pseudorandom noise code) to obtain an encoded message. The process of encoding may include performing a bitwise exclusive-OR of the bit sequence with the digital message. Subsequently, a digital to analogue converter (not shown) may convert the encoded digital message to an analogue signal. The analogue signal may be modulated (e.g. with a sine wave having a modulation frequency) to produce a modulated signal. The modulated analogue signal may be transmitted, by the SSTDR generator, into the electrical system 209. The SSTDR generator may include a receiver for receiving the reflection of the transmitted signal. The received signal may be extracted by demodulating the reflected signal using the sine wave having the modulation frequency, converting the demodulated signal to an analogue signal using an analogue to digital converter (not shown) and, then decoding the reflected signal (e.g. by performing a bitwise exclusive-OR of the demodulated received signal with the bit sequence). This results in a digitised version of the received signal, which can be processed further. The digitised received signal may subsequently be correlated (e.g. cross-correlated) with the transmitted signal to obtain the measured waveform signal. The cross-correlation may be undertaken by a correlation circuit implemented on a field-programmable gate array (FPGA) (not shown).

The analysis of the measured waveform signal may comprise determining a change of state based on an amplitude of the difference waveform and/or a location of a peak of the difference waveform.

The control unit 203 may control operation of the reflectometry generator 203 and/or provide a user interface for notifying an operator when/where a change of state in the electrical system has been detected.

The difference waveform may be input into a trained classifier, such as an artificial neural network, for determining if there is a change of state in the electrical system. Other suitable machine learning techniques may be utilised to analyse the difference waveform. The trained classifier may be trained to recognise the specific type of change of state in the electrical system that is indicated by a particular difference waveform. The training data for the neural network may include a database of difference waveforms and corresponding changes to an electrical system that each difference waveform indicates. The trained classifier may be specific to a particular design of electrical system, or be common to multiple designs of electrical system. Particular difference waveforms may be recognised via the trained classifier to indicate particular changes of state for different types of electrical systems which are being monitored. The trained classifier may be continuously trained based on changes of state and corresponding difference waveform that are detected from multiple monitored electrical systems.

In some examples, the processing unit 202 and storage device 205 are located remotely to the PES 209 and reflectometry generator 207. For example, the processing unit 202 and storage device may be embodied in one or more servers, or a cloud computing environment. Multiple different reflectometry generators monitoring different electrical systems 209 may be connected to the same processing unit 202. In these instances, a connection 211 to the reflectometry generator 207 may be a network such as the internet. A user may control the processing unit and be notified of a change of state in the electrical system 209 via the control unit 203, which may embodied as a computer terminal accessing the processing unit 202 via the internet or other communications network. The control unit 203 may comprise software including a web browser for enabling a user to control the analysis module 204 or other aspects of the monitoring apparatus 201 via the internet.

Fig. 3 is a flow diagram of a method according to this disclosure. During step 301, reflectometry data of the electrical system is received by performing time domain reflectometry on the electrical system having multiple electrical ground connection points, the time domain reflectometry being performed during a measurement time period. Typically the time domain reflectometry is performed via a reflectometry generator such as an SSTDR generator. The reflectometry data is indicative of a state of the electrical system. The reflectometry generator normally functions by transmitting an electric signal through the electrical system, and receiving a corresponding reflected signal. Step 302, comprises determining a measured waveform from the reflectometry data, the measured waveform representing a measured state of the system during the measurement time period. Step 303 comprises obtaining a baseline waveform representing a baseline state of the system during a calibration time period. Typically, the calibration time period is earlier than the measurement time period. The calibration time period may be during a time when the electrical system is being installed. Step 304 comprises generating a difference waveform based on the measured waveform and the baseline waveform. Step 305 comprises analysing the difference waveform to determine if there is a change of state in the electrical system between the calibration time period and measurement time period. This analysis may include a comparison of the difference waveform with a database of stored difference waveforms, which each correspond to a particular change of state of the electrical system. The stored difference waveforms may comprise digitised samples of predetermined difference waveforms.

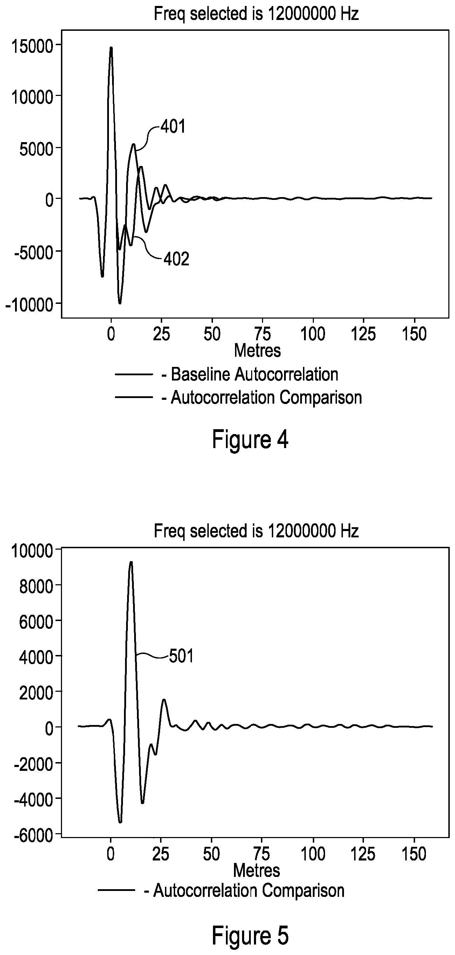

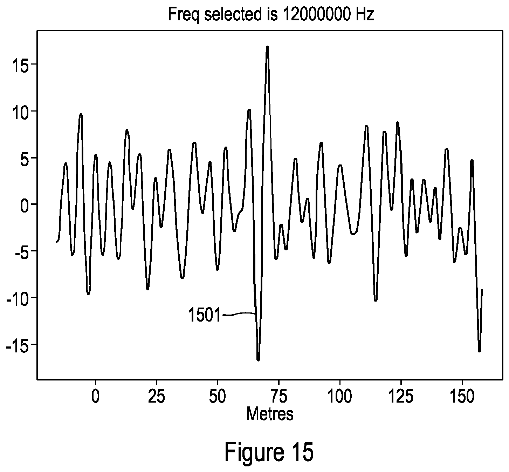

With reference to Fig. 4, there is shown a plot showing an example baseline waveform 402 superimposed on a measured waveform 401 of an electrical system. Both waveforms are the result of a correlation between transmitted and received signals obtained by a reflectometry generator connected to the electrical system, for example, in the manner exemplified in Figs. 1 to 3. The baseline waveform 402 is obtained from when the electrical system has no fault or abnormal change of state. The measured waveform 401 is obtained at a different time to the baseline waveform, and when a fault is present in the system. It can be observed that the baseline and measured waveforms are different. With reference to Fig. 5, there is shown a plot of a difference waveform 501, which is based on the difference between the waveform 401, 402 of Fig. 4. In examples of this disclosure, the difference waveform 501 is analysed to determine if there is a fault and/or change of state in the monitored electrical system. Analysis of the difference waveform 501 may also indicate the nature of the change of state of an electrical system, and/or the location of the change of state of the electrical system. In the event that there has been no change of state of the electrical system, then it would be expected that the waveform in the plot of Fig. 5 would not show any discernible difference waveform beyond background noise - as exemplified in Fig. 15 as will be discussed below. The analysis of the difference waveform may be undertaken using computational methods, which may involve converting the difference waveform to the frequency domain using a Fourier transform.

The systems and methods discussed herein utilise a baseline waveform of an electrical system. The baseline waveform depends on the state of an electrical system when there is no abnormal fault or change of state. For permanently earthed systems, the baseline waveform takes account of the earthing arrangement of the electrical system. The baseline waveform is typically obtained using reflectometry methods at a time when the electrical system is in a baseline condition - i.e. no faults or abnormal changes. The difference waveform is obtained based on a difference between the baseline waveform and a newly obtained measured waveform, and analysis of the difference waveform provides an indication that there has been a change in the earthing system arrangement. For example, with continued reference to Fig. 1, it is possible to determine if there is an interruption to any of the earth connections 102a, 102b, and 102c. In particular, multiple earth bonding connections within the electrical system can be monitored at once, and operators can be notified when they have changed state. Furthermore, critical components of electrical systems can be monitored. In the example of Fig. 1, conductor 103 may be a contact wire that is susceptible to theft, damage, or failure. The ground connections 102a, 102b, 102c may comprise earthing cables (not shown) that are also susceptible to theft, damage, or failure. An operator can be notified in real-time when such components are disturbed and therefore take remedial action quickly to ensure safe operation of a railway and avoid catastrophic damage to the OLE or train as a result of any fault or change to the electrical system. The operator may also be notified of the location of the fault/change of state, which is desirable for ensuring quick repair. This is particularly advantageous where the monitored electrical system spans a distance of several kilometres or more. The discussed systems and methods also provide the ability to detect permanent and intermittent faults (e.g. an arc fault) on an earthing system arrangement.

The following examples relate to testing that has been undertaken to demonstrate the functionality of the discussed systems and methods for monitoring electrical systems. The testing has been undertaken on a test rig simulating a permanently earthed section (PES) of an overhead line equipment (OLE) for a train line. SSTDR reflectometry has been used for monitoring in these tests. The tests demonstrated that the discussed methods and systems enable observation of not only changes in a main contact wire of an OLE, but also, changes to structures providing earth bonding in a PES such as dropper links across insulators in series with a ground connection, bondings between a mast and a cantilever of an OLE, and masts or other rigid structural elements of the OLE.

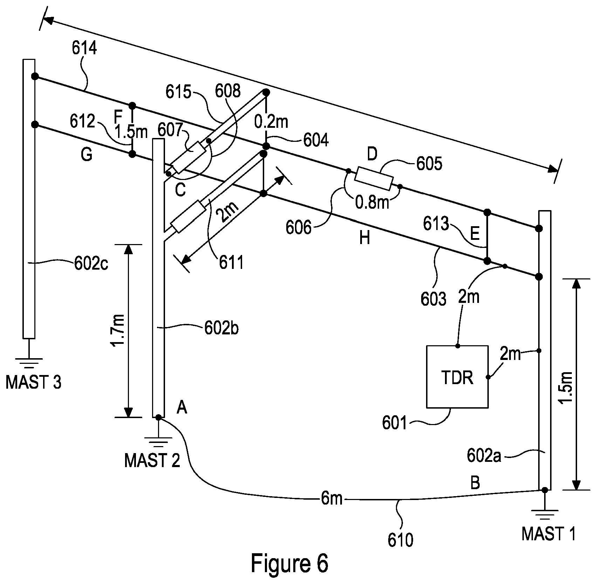

With reference to Figure 6, there is shown a test rig for demonstration functionality of aspects of this disclosure. The test rig can be considered analogous to a real-world implementation of aspects of this disclosure.

The test rig comprises three masts 602a, 602b, 602c that are electrically grounded. An electrical contact wire 603 is connected between masts 602a, 602c, and (via a substantially horizontal cantilever 611) mast 602c. The electric contact wire 603 is therefore grounded via the masts 602a, 602b, 602c. The electrical contact wire 603 is additionally suspended from droppers 612, 613 extending from a messenger wire 614. An isolator 605 impedes current along the messenger wire 614, and is bypassed by a jumper 605. Another isolator 607 impedes current along a cantilever 615. Another jumper 608 bypasses the isolator 607. A return path 610 is connected between masts 602a and 602b. The structural features which are supported by the masts 602a, 602b, 602c are at the same electrical potential. The components supported by the masts 602a, 602b, 602c, and the ground connections enabled by the masts themselves, make up an electrical system which is being monitored. An SSTDR reflectometry generator 601 is connected in between mast 602a and the electrical contact wire 603. During each test, the SSTDR reflectometry generator transmitted a signal across the contact cable 603 and the mast 602a, and received a corresponding reflection. The transmitted and reflected signals were correlated to obtain the waveforms discussed below. For each test, the same frequency was used to transmit the SSTDR signals for obtaining both baseline and measured waveforms , although different frequencies were utilised for different tests.

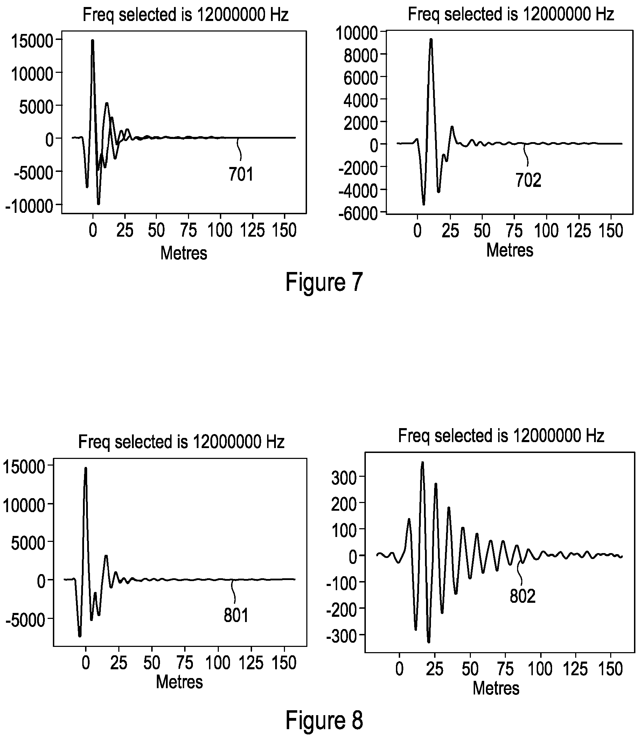

Figures 7 to 14 indicate test results under different simulated changes of state of the test rig. Each test involved obtaining a correlated baseline waveform when there is no change of state, and a correlated measured waveform when the test rig was subjected to a change of state. In some cases, the differences between the waveforms are not visually discernable on the plots of Figures 7 to 14, and therefore both of these waveforms are indicated by a single reference numeral - 701, 801, 901, 1001, 1101, 1201, 1301, and 1401 for the sake of clarity. The difference between the baseline and measured waveforms for each test is shown via the difference waveforms 702, 802, 902, 1002, 1102, 1202, 1302, and 1402. In each case, the plots showing the difference waveforms utilise different scales on the axes compared to the corresponding baseline/measured waveform plot, for the sake of visibility. Typically, the baseline and measured waveforms are obtained at the same frequency as each other.

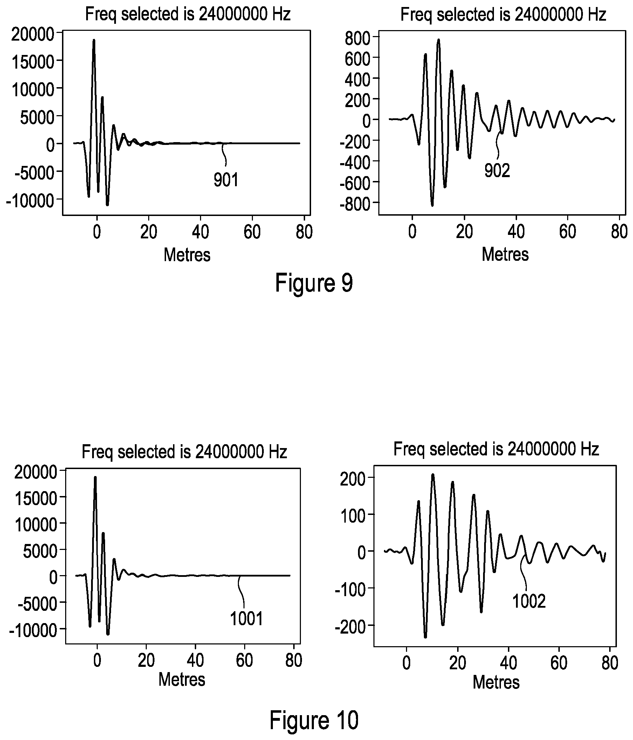

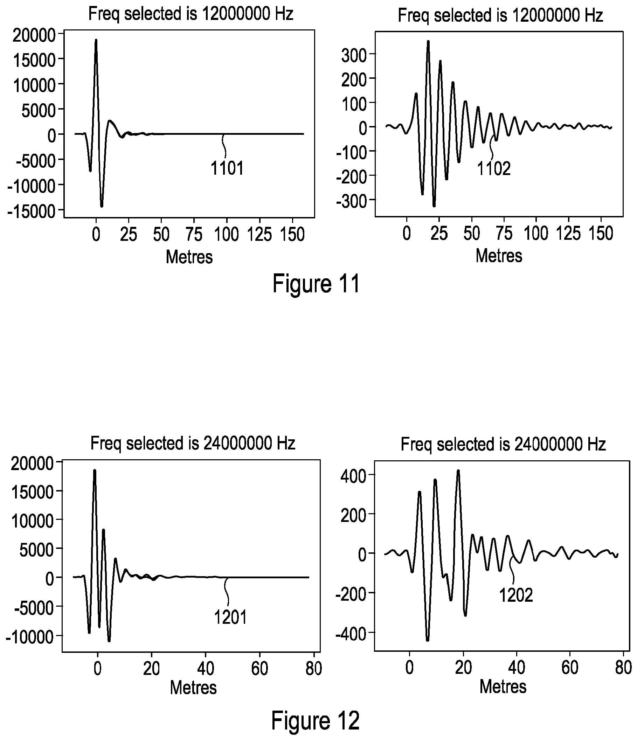

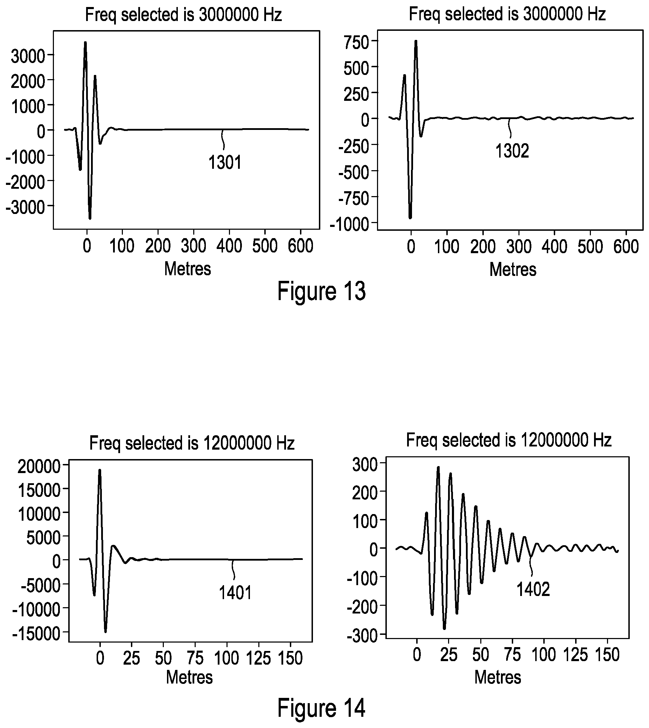

With continued reference to Fig. 6, the results of Fig. 7 were obtained when the change of state of the test rig involved disconnecting the return path at point B thereby simulating a damaged ground connection. The maximum amplitude of the difference waveform 702 was 9500. The amplitude of the difference waveform is dimensionless, since it is a relative measure of an electrical parameter. The results of Fig. 8 were obtained when the change of state of the test rig involved removal of the jumper 608, thereby simulating theft/damage of the jumper 608. The maximum amplitude of the difference waveform 802 was 550. The results of Fig. 9 were obtained when the change of state of the test rig involved removal of the jumper 606, thereby simulating theft/damage of the jumper 606. The maximum amplitude of the difference waveform 902 was 550. The results of Fig. 10 were obtained when the change of state of the test rig involved removal of the dropper 613, thereby simulating theft/damage of the dropper 613. The maximum amplitude of the difference waveform 1002 was 220. The results of Fig. 11 were obtained when the change of state of the test rig involved removal of the dropper 612, thereby simulating theft/damage of the dropper 612. The maximum amplitude of the difference waveform 1102 was 400. The results of Fig. 12 were obtained when the change of state of the test rig involved cutting the contact cable 603 at point G. The maximum amplitude of the difference waveform 1202 was 410. The results of Fig. 13 were obtained when the change of state of the test rig involved cutting the contact cable at point H. The maximum amplitude of the difference waveform 902 was 1000. The results of Fig. 14 were obtained when the change of state of the test rig involved cutting the contact cable 603 at point G. Both the baseline and change of state configurations included disconnection of the return path 610. The maximum amplitude of the difference waveform 1402 was 300.

It can be observed from Figures 7 to 14, particularly, from curves 702, 802, 902, 1002, 1102, 1202, 1302, and 1402, that firstly, each change of state is clearly detected, and secondly, that the shape and amplitude of the difference waveforms vary significantly depending on the nature and location of the change of state of the electrical system being monitored. Therefore, it is possible to determine the location/nature of changes of states of the electrical system by comparison of a difference waveform with a database of known difference waveforms, and/or by utilising knowledge about characteristics of the difference waveforms. Such a comparison may be undertaken computationally. As discussed above, machine learning and a trained classifier can be utilised to ascertain relevant information based on characteristics of a difference waveform. It is also possible to recognise the effect of other factors that would ordinarily interrupt monitoring, for example, the effect of passing trains or adverse weather on components of the electrical system. Where previously these events might "trigger" a monitoring system due to a temporary change in SSTDR characteristics, methods of the present disclosure would enable such events to be recognised as non-concerning.

With reference to Fig. 15, there is an exemplary difference wave obtained when there is no change of state in the electrical system, in effect, indicating background noise. It can be observed that the amplitude is very low (around 30), which is 7.3 times lower than the lowest amplitude observed during a change of state indicated in the plots of Figs. 7 to 14. It is therefore easy to distinguish when a change of state has or has not occurred.

## Claims

1. A method for monitoring an electrical system (209) having multiple electrical ground connection points, the method comprising:
receiving (301) reflectometry data that has been generated by performing time domain reflectometry on the electrical system, the time domain reflectometry being performed during a measurement time period;
determining (302) a measured waveform (401) from the reflectometry data, the measured waveform (401) indicative of a measured state of the system during the measurement time period;
obtaining (303) a predetermined baseline waveform (402) indicative of a baseline state of the system during a calibration time period;
generating (304) a difference waveform (501, 702, 802, 902, 1002, 1102, 1202, 1302, 1402) based on the measured waveform (401) and the baseline waveform (402); and
analysing (305) the difference waveform (501, 702, 802, 902, 1002, 1102, 1202, 1302, 1402) to determine if there is a change of state in the electrical system between the calibration time period and measurement time period, wherein analysing the difference waveform (501, 702, 802, 902, 1002, 1102, 1202, 1302, 1402) comprises comparing the difference waveform with two or more stored difference waveforms, and wherein each of the two or more stored difference waveforms corresponds to a known change of state.

2. A method according to claim 1, wherein the time domain reflectometry is performed by transmitting and receiving signals along a grounded conductor having multiple electrical ground connection points.

3. A method according to any preceding claim, wherein the change of state comprises a change of state of a ground connection of the electrical system (209).

4. A method according to any preceding claim, wherein the change of state comprises a change to a conductive structure supporting a conductor (103) of the electrical system (209).

5. A method according to any preceding claim, wherein the reflectometry is one of time domain reflectometry (TDR), Sequence Time Domain Reflectometry (STDR), and Spread Spectrum Time Domain Reflectometry (SSTDR).

6. A method according to any preceding claim, wherein analysing the difference waveform comprises one or more of: determining if there is a change of state based on an amplitude of the difference waveform; determining if there is a change of state based on a location of a peak of the difference waveform; and inputting the difference waveform into a trained classifier for determining if there is a change of state in the electrical system.

7. A method according to any preceding claim, wherein the reflectometry data is received by a local monitoring system, and is transmitted to a server which is remote to the local monitoring system, and wherein the difference waveform is analysed by the server.

8. A method according to any preceding claim, wherein analysing the difference waveform (501, 702, 802, 902, 1002, 1102, 1202, 1302, 1402) comprises determining one or both of a location within the electrical system (209), and a type of any change of state based on the difference waveform (501, 702, 802, 902, 1002, 1102, 1202, 1302, 1402).

9. A method according to claim 8, further comprising generating an alarm when a change of state is determined, and generating an indication of the one or both of the location and type of change of state.

10. A method according to any previous claim, further comprising obtaining a plurality of sets of reflectometry data of the electrical system (209), wherein each set of reflectometry data is obtained under a different simulated change of state of the system, and wherein each of the plurality of sets of reflectometry data comprise a simulated difference waveform corresponding to the respective simulated change of state of the system, and wherein each simulated difference waveform is stored as training data.

11. A method according to claim 10, further comprising training a classifier by inputting the plurality of sets of reflectometry data and corresponding simulated change of state of the system into the classifier.

12. An apparatus for monitoring an electrical system (209), the apparatus comprising a processing unit (202) including means configured to undertake the method of any of claims 1 to 11.

13. An apparatus according to claim 12, further comprising a reflectometry generator (207) configured to be connected to a conductor of the electrical system (209), the reflectometry generator (207) configured to obtain test reflectometry data of the electrical system (209).

14. An apparatus according to claim 12 or claim 13, wherein the processing unit (202) is located on a server remote to the electrical system (209).

15. A computer-readable storage medium comprising instructions for execution by a processor, wherein the instructions are configured to cause the processor to perform a method according to any of claims 1 to 11.

## Patentansprüche

1. Verfahren zum Überwachen eines elektrischen Systems (209), das mehrere elektrische Erdungsanschlusspunkte aufweist, wobei das Verfahren Folgendes umfasst:
Empfangen (301) von Reflektometriedaten, die durch Durchführen einer Zeitbereichsreflektometrie an dem elektrischen System erzeugt wurden, wobei die Zeitbereichsreflektometrie während eines Messzeitraums durchgeführt wird;
Bestimmen (302) einer gemessenen Wellenform (401) aus den Reflektometriedaten, wobei die gemessene Wellenform (401) einen gemessenen Zustand des Systems während des Messzeitraums angibt;
Erhalten (303) einer vorbestimmten Basislinienwellenform (402), die einen Basislinienzustand des Systems während eines Kalibrierungszeitraums angibt;
Erzeugen (304) einer Differenzwellenform (501, 702, 802, 902, 1002, 1102, 1202, 1302, 1402) basierend auf der gemessenen Wellenform (401) und der Basislinienwellenform (402); und
Analysieren (305) der Differenzwellenform (501, 702, 802, 902, 1002, 1102, 1202, 1302, 1402), um zu bestimmen, ob zwischen dem Kalibrierungszeitraum und dem Messzeitraum eine Zustandsänderung in dem elektrischen System vorliegt, wobei das Analysieren der Differenzwellenform (501, 702, 802, 902, 1002, 1102, 1202, 1302, 1402) das Vergleichen der Differenzwellenform mit zwei oder mehr gespeicherten Differenzwellenformen umfasst, und wobei jede der zwei oder mehr gespeicherten Differenzwellenformen einer bekannten Zustandsänderung entspricht.

2. Verfahren nach Anspruch 1, wobei die Zeitbereichsreflektometrie durch Übertragen und Empfangen von Signalen entlang eines geerdeten Leiters, der mehrere elektrische Erdungsanschlusspunkte aufweist, durchgeführt wird.

3. Verfahren nach einem vorstehenden Anspruch, wobei die Zustandsänderung eine Zustandsänderung einer Erdungsverbindung des elektrischen Systems (209) umfasst.

4. Verfahren nach einem vorstehenden Anspruch, wobei die Zustandsänderung eine Änderung einer leitfähigen Struktur umfasst, die einen Leiter (103) des elektrischen Systems (209) trägt.

5. Verfahren nach einem vorstehenden Anspruch, wobei die Reflektometrie eine von Zeitbereichsreflektometrie (TDR), Sequenz-Zeitbereichsreflektometrie (STDR) oder Spread-Spectrum-Zeitbereichsreflektometrie (SSTDR) ist.

6. Verfahren nach einem vorstehenden Anspruch, wobei das Analysieren der Differenzwellenform eines oder mehrere der Folgenden umfasst: Bestimmen, ob eine Zustandsänderung vorliegt, basierend auf einer Amplitude der Differenzwellenform; Bestimmen, ob eine Zustandsänderung vorliegt, basierend auf einem Ort einer Spitze der Differenzwellenform; und Eingeben der Differenzwellenform in einen trainierten Klassifikator zum Bestimmen, ob eine Zustandsänderung in dem elektrischen System vorliegt.

7. Verfahren nach einem vorstehenden Anspruch, wobei die Reflektometriedaten von einem lokalen Überwachungssystem empfangen und an einen Server übertragen werden, der sich entfernt von dem lokalen Überwachungssystem befindet, und wobei die Differenzwellenform von dem Server analysiert wird.

8. Verfahren nach einem vorstehenden Anspruch, wobei das Analysieren der Differenzwellenform (501, 702, 802, 902, 1002, 1102, 1202, 1302, 1402) das Bestimmen eines oder beider eines Orts innerhalb des elektrischen Systems (209) und einer Art einer Zustandsänderung basierend auf der Differenzwellenform (501, 702, 802, 902, 1002, 1102, 1202, 1302, 1402) umfasst.

9. Verfahren nach Anspruch 8, das weiter das Erzeugen eines Alarms bei Bestimmen einer Zustandsänderung und das Erzeugen einer Angabe des Orts oder sowohl des Orts als auch der Art der Zustandsänderung umfasst.

10. Verfahren nach einem vorstehenden Anspruch, das weiter das Erhalten einer Vielzahl von Reflektometriedatensätzen des elektrischen Systems (209) umfasst, wobei jeder Reflektometriedatensatz unter einer unterschiedlichen simulierten Zustandsänderung des Systems erhalten wird und wobei jeder der Vielzahl von Reflektometriedatensätzen eine simulierte Differenzwellenform umfasst, die der jeweiligen simulierten Zustandsänderung des Systems entspricht, und wobei jede simulierte Differenzwellenform als Trainingsdaten gespeichert wird.

11. Verfahren nach Anspruch 10, das weiter das Trainieren eines Klassifikators durch Eingeben der Vielzahl von Reflektometriedatensätzen und der entsprechenden simulierten Zustandsänderung des Systems in den Klassifikator umfasst.

12. Einrichtung zum Überwachen eines elektrischen Systems (209), wobei die Einrichtung eine Verarbeitungseinheit (202) umfasst, die Mittel beinhaltet, die dazu konfiguriert sind, das Verfahren nach einem der Ansprüche 1 bis 11 vorzunehmen.

13. Einrichtung nach Anspruch 12, die weiter einen Reflektometriegenerator (207) umfasst, der dazu konfiguriert ist, mit einem Leiter des elektrischen Systems (209) verbunden zu werden, wobei der Reflektometriegenerator (207) dazu konfiguriert ist, Testreflektometriedaten des elektrischen Systems (209) zu erhalten.

14. Einrichtung nach Anspruch 12 oder Anspruch 13, wobei sich die Verarbeitungseinheit (202) auf einem Server befindet, der von dem elektrischen System (209) entfernt ist.

15. Computerlesbares Speichermedium, das Anweisungen zur Ausführung durch einen Prozessor umfasst, wobei die Anweisungen dazu konfiguriert sind, den Prozessoren zu veranlassen, ein Verfahren nach einem der Ansprüche 1 bis 11 durchzuführen.

## Revendications

1. Procédé de surveillance d'un système électrique (209) présentant de multiples points de connexion électrique à la terre, le procédé comprenant :
la réception (301) de données de réflectométrie qui ont été générées en effectuant une réflectométrie dans le domaine temporel sur le système électrique, la réflectométrie dans le domaine temporel étant effectuée pendant une période de temps de mesure ;
ma détermination (302) d'une forme d'onde mesurée (401) à partir des données de réflectométrie, la forme d'onde mesurée (401) étant indicative d'un état mesuré du système pendant la période de temps de mesure ;
l'obtention (303) d'une forme d'onde de référence prédéterminée (402) indicative d'un état de référence du système pendant une période de temps d'étalonnage ;
la génération (304) d'une forme d'onde de différence (501, 702, 802, 902, 1002, 1102, 1202, 1302, 1402) sur la base de la forme d'onde mesurée (401) et de la forme d'onde de référence (402) ; et
l'analyse (305) de la forme d'onde de différence (501, 702, 802, 902, 1002, 1102, 1202, 1302, 1402) pour déterminer s'il existe un changement d'état dans le système électrique entre la période de temps d'étalonnage et la période de temps de mesure, dans lequel l'analyse de la forme d'onde de différence (501, 702, 802, 902, 1002, 1102, 1202, 1302, 1402) comprend une comparaison de la forme d'onde de différence avec deux formes d'onde de différence stockées ou plus, et dans lequel chacune des deux formes d'onde de différence stockées ou plus correspond à un changement d'état connu.

2. Procédé selon la revendication 1, dans lequel la réflectométrie dans le domaine temporel est effectuée en transmettant et en recevant des signaux le long d'un conducteur mis à la terre présentant de multiples points de connexion électrique à la terre.

3. Procédé selon une quelconque revendication précédente, dans lequel le changement d'état comprend un changement d'état d'une connexion à la terre du système électrique (209).

4. Procédé selon une quelconque revendication précédente, dans lequel le changement d'état comprend un changement d'une structure conductrice supportant un conducteur (103) du système électrique (209).

5. Procédé selon une quelconque revendication précédente, dans lequel la réflectométrie est l'une d'une réflectométrie dans le domaine temporel (TDR), d'une réflectométrie dans le domaine temporel par séquence(STDR) et d'une réflectométrie dans le domaine temporel à spectre étalé (SSTDR).

6. Procédé selon une quelconque revendication précédente, dans lequel l'analyse de la forme d'onde de différence comprend une ou plusieurs des étapes suivantes : déterminer s'il existe un changement d'état sur la base d'une amplitude de la forme d'onde de différence ; déterminer s'il existe un changement d'état sur la base d'un emplacement d'un pic de la forme d'onde de différence ; et entrer la forme d'onde de différence dans un classificateur entraîné pour déterminer s'il existe un changement d'état dans le système électrique.

7. Procédé selon une quelconque revendication précédente, dans lequel les données de réflectométrie sont reçues par un système de surveillance local, et sont transmises à un serveur qui est distant du système de surveillance local, et dans lequel la forme d'onde de différence est analysée par le serveur.

8. Procédé selon une quelconque revendication précédente, dans lequel l'analyse de la forme d'onde de différence (501, 702, 802, 902, 1002, 1102, 1202, 1302, 1402) comprend la détermination d'un ou des deux emplacements dans le système électrique (209) et d'un type de tout changement d'état basé sur la forme d'onde de différence (501, 702, 802, 902, 1002, 1102, 1202, 1302, 1402).

9. Procédé selon la revendication 8, comprenant en outre une génération d'une alarme lorsqu'un changement d'état est déterminé, et une génération d'une indication de l'un de l'emplacement et du type de changement d'état, ou des deux.

10. Procédé selon une quelconque revendication précédente, comprenant en outre une obtention d'une pluralité d'ensembles de données de réflectométrie du système électrique (209), dans lequel chaque ensemble de données de réflectométrie est obtenu sous un changement d'état simulé différent du système, et dans lequel chacun de la pluralité d'ensembles de données de réflectométrie comprend une forme d'onde de différence simulée correspondant au changement d'état simulé respectif du système, et dans lequel chaque forme d'onde de différence simulée est stockée en tant que données d'apprentissage.

11. Procédé selon la revendication 10, comprenant en outre la formation d'un classificateur en entrant la pluralité d'ensembles de données de réflectométrie et le changement d'état simulé correspondant du système dans le classificateur.

12. Appareil de surveillance d'un système électrique (209), l'appareil comprenant une unité de traitement (202) incluant des moyens configurés pour mettre en œuvre le procédé selon l'une quelconque des revendications 1 à 11.

13. Appareil selon la revendication 12, comprenant en outre un générateur de réflectométrie (207) configuré pour être connecté à un conducteur du système électrique (209), le générateur de réflectométrie (207) étant configuré pour obtenir des données de réflectométrie de test du système électrique (209).

14. Appareil selon la revendication 12 ou la revendication 13, dans lequel l'unité de traitement (202) est située sur un serveur distant du système électrique (209).

15. Support de stockage lisible par ordinateur comprenant des instructions à exécuter par un processeur, dans lequel les instructions sont configurées pour amener le processeur à effectuer un procédé selon l'une quelconque des revendications 1 à 11.
